(19) Europäisches Patentamt
European Patent Office
Office européen des brevets

(11) **EP 4 143 828 B1**

(12) **EUROPÄISCHE PATENTSCHRIFT**

(45) Veröffentlichungstag und Bekanntmachung des Hinweises auf die Patenterteilung:
**01.07.2026  Patentblatt 2026/27**

(21) Anmeldenummer: **21727084.2**

(22) Anmeldetag: **29.04.2021**

(51) Internationale Patentklassifikation (IPC):
*G06G 7/163* *(2006.01)*

(52) Gemeinsame Patentklassifikation (CPC):
**G11C 11/24; G06G 7/163; G06N 3/0464; G11C 11/54;** G06N 3/045; G06N 3/065

(86) Internationale Anmeldenummer:
**PCT/EP2021/061334**

(87) Internationale Veröffentlichungsnummer:
**WO 2021/219822 (04.11.2021 Gazette 2021/44)**

(54) **ANORDNUNG UND VERFAHREN ZUR DURCHFÜHRUNG EINER VEKTOR-MATRIX MULTIPLIKATION MIT KAPAZITIVEN ODER RESISTIVEN SYNAPTISCHEN BAUELEMENTEN**

ARRANGEMENT AND METHOD FOR PERFORMING A VECTOR-MATRIX MULTIPLICATION BY MEANS OF CAPACITIVE OR RESISTIVE SYNAPTIC COMPONENTS

AGENCEMENT ET PROCÉDÉ POUR EFFECTUER UNE MULTIPLICATION DE MATRICE VECTORIELLE AU MOYEN DE COMPOSANTS SYNAPTIQUES CAPACITIFS OU RÉSISTIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.04.2020  EP 20172081**
**24.07.2020  EP 20187663**

(43) Veröffentlichungstag der Anmeldung:
**08.03.2023  Patentblatt 2023/10**

(73) Patentinhaber: **Semron GmbH**
**01067 Dresden (DE)**

(72) Erfinder:
• **DEMASIUS, Kai-Uwe**
**01324 Dresden (DE)**
• **KIRSCHEN, Aron**
**01309 Dresden (DE)**

(74) Vertreter: **Lippert Stachow Patentanwälte Rechtsanwälte
Partnerschaft mbB
Königsbrücker Straße 124
01099 Dresden (DE)**

(56) Entgegenhaltungen:
EP-A1- 0 428 716    CN-A- 110 991 623
US-A- 5 343 555

**Beschreibung**

Die vorliegende Erfindung betrifft eine Anordnung zur Durchführung einer Vektor-Matrix Multiplikation mit synaptischen Bauelementen, bestehend aus einer Matrixanordnung von kapazitiven oder resistiven oder kapazitiv-resistiven synaptischen Bauelementen in einer differentiellen Anordnung, welche periodisch geladen und entladen werden, und einem Taktgenerator, welcher die Bitleitungen abwechselnd mit einem Ladungsintegrationsverstärker oder einer Masse über einen Wechselschalter verbindet.

Ebenfalls betrifft die Erfindung ein Verfahren zur Ansteuerung der Anordnung, um die Vektor-Matrix Multiplikation zu erzielen.

Unter einem synaptischen Bauelement wird ein Bauelement zur gewichteten Multiplikation in künstlichen neuronalen Netzen verstanden.

Vektor-Matrix Multiplikationen kommen häufig in künstlichen neuronalen Netzen zum Einsatz und sind extrem rechenintensiv bei der Implementierung auf konventionellen digitalen Rechnerarchitekturen.

Künstliche Neuronalen Netze haben in den vergangenen Jahren eine steigende Bedeutung in Bild- und Objekterkennung und Datenverarbeitung gewonnen und werden zukünftig eine wichtige Relevanz haben in der Implementierung von künstlicher Intelligenz.

In künstlichen Neuronalen Netzten werden die Ausgänge von künstlichen Neuronen über synaptische Verknüpfungen mit Eingängen von weiteren künstlichen Neuronen verbunden. Die synaptischen Verknüpfungen bewerkstelligen eine gewichtete Multiplikation mit den Ausgangssignalen der künstlichen pre-Neuronen. Als eine günstige Anordnung von künstlichen synaptischen Bauelementen hat sich in den vergangenen Jahren eine Matrixanordnung herausgestellt, da jedes pre-Neuron über die Wortleitungen mit jedem post-Neuron über die Bitleitungen verbunden ist, und somit eine hohe Verbindungsdichte erzielt werden kann (Tsai et al.: Recent progress in analog memory-based accelerators for deep learning). An den Bitleitungen werden die einzelnen Multiplikationen aufsummiert, und somit wird eine Multiplikations- und Akkumulationsoperation erzielt. Die Neuronen sind häufig nichtlineare Funktionen (z.B. Sigmoid oder ReLU) oder können eine zeitliche Integration mit Schwellwert sein.

Zur physikalischen Implementation werden häufig resistive Bauelemente, wie z.B. Memristoren (US20180019011A1), Phase-Change-Memory oder Floating Gate Transistoren eingesetzt. Ebenso denkbar ist die Ausnutzung memkapazitiver Bauelemente (US20120014170A1, WO2011025495A1, DE102014105639B3, US5524092A1, US2019303744A1, Ventra et al.: Circuit elements with memory- memristors, memcapacitors, and meminductors, Proceedings of the IEEE), welche den Vorteil eines geringeren statischen Stromverbrauches haben und dynamische Verluste können mit einer adiabatischen Aufladung zum Großenteil beseitigt werden.

Es ist ebenso bereits bekannt, dass die Eingangssignale zur Erzielung einer gewichteten Multiplikation unterschiedlich kodiert werden können: Als Variation der Eingangsspannung oder als Variation einer zeitlichen Länge eines Eingangspulses (Tsai et al.: Recent progress in analog memory-based accelerators for deep learning).

In US20120014170A1 wurde bereits eine Matrixanordnung von kapazitiven synaptischen Bauelementen vorgeschlagen und ebenso ein Verfahren zum Beschreiben und Auslesen beschrieben. Das Auslesen erfolgt dabei über Spannungspulse. In WO2016068886A1 wurde die Nutzung eines Wechselsignals beim Auslesen vorgeschlagen und, dass kapazitive Bauelemente unter Ausnutzung dynamischer Größen Vorteile gegenüber resistiven synaptischen Bauelementen besitzen. Auch wurde die Ausgangsstromabhängigkeit von der Frequenz der Eingangsgröße erläutert.

Die CN 110991623 A offenbart eine Multiplikations-Anordnung für analoge Neuronen. Die Multiplikationsschaltung wird zur Multiplikation der binären Gewichtung der Eingangsdaten und eines Festkomma-Quantisierungsaktivierungswerts verwendet. Der Multiplikationsschaltkreis enthält N * m XOR-Logikschaltkreise, die verwendet werden, um jedes Bit des binären Gewichts der einzelnen Dimensionsdaten der N Dimensionen der Eingangsdaten und den Festkomma-Quantisierungsaktivierungswert der Dimensionsdaten zu multiplizieren.

In US5343555 wurde eine switched capacitor Anordnung für das Auslesen von exhibitorischen und inhibitorischen Synapsen vorgeschlagen. Bei den Synapsen handelt sich nach wie vor nicht um memkapazitive Bauelemente direkt, sondern es werden Aufladungen von gewöhnlichen Kapazitäten genutzt und der Speicherinhalt von Floating Gate Transistoren. Das synaptische Bauelement nimmt damit noch deutlich mehr Fläche ein. Der Erfindung liegt aber bereits zu Grunde, dass ein Ladungsintegrationsverstärker genutzt wird, und die synaptischen Kapazitäten durch zwei nicht überlagernde Taktpulse periodisch geladen und entladen werden und die Ladung auf den Ladungsintegrationsverstärker übertragen wird. Ebenso werden die unterschiedlichen Phasen der exhibitorischen und inhibitorischen Synapse beschrieben. Die Erfindung nutzt jedoch noch als Eingangssignal eine zeitliche Pulsweitenänderung, nicht jedoch ein Wechselsignal. Dementsprechend wird in dem Eingangssignal oder den Gewichten keine Phasenänderung ausgenutzt und entsprechend keine Vier-Quadranten Multiplikation durchgeführt, welche jedoch häufig nötig ist in künstlichen neuronalen Netzen. Da das Patent jedoch der hier beschriebenen Erfindung am Nächsten kommt, wird diese als Stand der Technik hier benutzt.

Der Erfindung lag deshalb die Aufgabe zu Grunde, eine switched capacitor Anordnung zu implementieren, welche kapazitive, resistive oder kapazitiv-resistive Bauelemente nutzt und verschiedene Variationen eines Wechselspannungssignals als Eingangsgröße nutzt. Mit diesem Schema soll eine Vier-Quadranten Multiplikation ermöglicht werden und der Oszillator für das Wechselspannungssignal, sowie die Frequenz, sollen so gestaltet sein, dass ein minimaler Energieverbrauch möglich wird.

Erfindungsgemäß wird diese Aufgabe anordnungsseitig durch eine Anordnung mit den Merkmalen des Anspruches 1 gelöst. Ausführungsformen hierzu sind in den abhängigen Ansprüchen 2 bis 10 dargestellt.

Weiterhin wird die erfindungsgemäße Aufgabenstellung durch ein Verfahren gemäß Anspruch 11 bis 13 gelöst. Verfahrensseitige Ausgestaltungen sind in den abhängigen Ansprüchen 14 bis 19 dargestellt.

Eine Anordnung der eingangsgenannten Art wird erfindungsgemäß dadurch gestaltet, dass die Wortleitungen der Matrix mit einer oder mehreren Oszillatoren verbunden werden und der Taktgenerator entweder auf steigende oder fallende Spannungen der Oszillatoren reagiert oder auf einen positiven oder negativen Wertebereich der Spannung der Oszillatoren reagiert.

In einer Ausführungsform für kapazitive synaptische Bauelemente reagiert der Taktgenerator auf steigende oder fallende Flanken, bei denen die Kapazitäten aufgeladen bzw. entladen werden, das heißt der Stromfluss und damit Ladungszu- und abfluss ist abhängig von der Ableitung der Spannungsänderung im Falle von kapazitiven synaptischen Bauelementen:

$$ I = \frac{dU}{dt} \cdot C $$

Da dieser Ladungszu- und abfluss letztlich an den Bitleitungen von den Ladungsintegrationsverstärkern integriert wird, ist bei kapazitiven synaptischen Bauelementen die steigende und abfallende Spannung des Oszillators entscheidend.

Ebenso denkbar ist in einer weiteren Ausführungsform, dass die Bitleitung im Falle von kapazitiven synaptischen Bauelementen, insbesondere von positiv und negativ definierten Kapazitäten, über eine feste Kapazität mit Masse verbunden ist und der Taktgenerator auf den positiven und negativen Wertebereich der Spannung des Oszillators reagierend ausgebildet ist. Der Spannungsabfall über die Kapazität ist 90° phasenverschoben zu dem Auflade- bzw. Entladestromes, weshalb diesmal der Taktgenerator nicht 90° phasenverschoben reagieren muss, wie beim vorherigen Ausführungsbeispiel. Die erwähnte Kapazität kann auch die parasitäre Kapazität der Bitleitung sein. In dem Fall muss der Ladungsintegrationsverstärker auf den Spannungsabfall über der festen Kapazität reagieren.

In einer Ausführungsform ist der Taktgenerator im Falle von resistiven synaptischen Bauelementen, insbesondere von positiv und negativ definierten Widerständen, auf den positiven und negativen Wertebereich der Spannung des Oszillators reagierend ausgebildet ist. In diesem Fall ist der Stromfluss nicht von der Ableitung der Spannung abhängig, sondern zu ihr proportional. Entsprechend braucht der Taktgenerator wieder keine 90° Phasenverschiebung.

In einer Ausführungsform besteht der Ladungsintegrationsverstärker aus einem Stromspiegel, in einer weiteren Ausführungsform aus Gate-Schaltung, und in einer weiteren wird die Ladung direkt auf einen Kondensator auf integriert. Zudem besteht die Möglichkeit in einer Ausführungsform eine Millerkapazität auszunutzen um eine niedrige eingangsseitige Impedanz zu erzielen.

Entscheidend für den Ladungsintegrationsverstärker ist eine niedrige Eingangsimpedanz, damit die Ladungen auf der Bitleitung hauptsächlich von dem Ladungsintegrationsverstärker aufgenommen werden und nicht in parasitären Kapazitäten oder Widerständen verloren geht.

Dies wird mit den 4 dargestellten Ausführungsformen ermöglicht. Parasitäre Kapazitäten können jedoch auch genutzt werden, wie zum Beispiel im Falle von Anspruch 3. In einer weiteren Ausführungsform kann der Oszillator einen Energiespeicher enthalten, welcher in einer weiteren Ausführungsform aus einer Induktivität bestehen kann. Hiermit können gespeicherte Ladungen in der Matrixanordnung effektiv zurückgewonnen werden und dynamische Verluste können mit einer adiabatischen Aufladung zum Großenteil beseitigt werden. Dies ermöglicht eine extrem hohe Energieeffizienz bei der Berechnung von künstlichen neuronalen Netzen.

Die verfahrensseitige Lösung der erfindungsgemäßen Aufgabenstellung zur Durchführung einer Vektor-Matrix-Multiplikation einer erfindungsgemäßen Anordnung besteht in folgenden fallweise definierten Schritten:

Im Falle einer Matrix von kapazitiven synaptischen Bauelementen und einem Taktgenerator, welcher auf den positiven oder negativen Gradienten reagiert:

- die Wechselspannungen einen festen Phasenbezug besitzen,

- im Falle einer abwechselnden Verbindung zwischen Masse und Eingang des Ladungsintegrationsverstärkers die Bitleitungen der positiv vorgesehenen Kapazitäten dann mit dem Eingang eines Ladungsintegrationsverstärkers verbunden wird, wenn ein positiver Gradient in dem positiv definierten Wechselspannungssignal der Wortleitung vorliegt, ansonsten mit Masse verbunden wird, was einen positiven Stromfluss in den Ladungsintegrationsverstärker bewirkt und zu einem positiven Spannungsabfall führt,

- die Bitleitung der als negativ vorgesehenen Kapazitäten, dann mit dem Eingang des Ladungsintegrationsverstärkers verbunden wird, wenn ein negativer Gradient im positiv definierten Wechselspannungssignal der Wortleitung vorliegt, ansonsten mit der Masse verbunden wird, was einen negativen Stromfluss in den Ladungsintegrationsverstärker bewirkt und zu einem negativen Spannungsabfall führt.

Hierdurch wird sichergestellt, dass das Wechselstromsignal an der Bitleitung effektiv gleichgerichtet und aufintegriert wird.

Im Falle eines differentiellen Ladungsintegrationsverstärkers können auch beide Phasen gleichgerichtet werden und ausgenutzt werden, wodurch die effektive Verstärkung verdoppelt wird:

- im Falle einer abwechselnden Verbindung zwischen invertierendem und nichtinvertierendem Eingang des Ladungsintegrationsverstärkers

  • die positiv vorgesehenen Kapazitäten dann mit dem nichtinvertierenden Eingang eines Ladungsintegrationsverstärkers verbunden wird, wenn ein positiver Gradient in dem positiv definierten Wechselspannungssignal der Wortleitung vorliegt, ansonsten mit dem invertierenden Eingang und

  • die negativ vorgesehenen Kapazitäten dann mit dem nichtinvertierenden Eingang eines Ladungsintegrationsverstärkers verbunden wird, wenn ein negativer Gradient in dem positiv definierten Wechselspannungssignal der Wortleitung vorliegt, ansonsten mit dem invertierenden Eingang.

Im Falle eines negativ definierten Wechselspannungssignals wird an der Wortleitung der positive und negative Gradient zeitlich vertauscht, sodass die positiven und negativen Ströme vertauscht sind.

Auf diese Weise kann eine Vierquadranten-Multiplikation erzielt werden.

In einem anderen Ausführungsbeispiel für resistive Bauelemente oder kapazitive Bauelemente mit zusätzlicher Kapazität an der Bitleitung wird entweder der Strom in Phase oder der Spannungsabfall in Phase über die zusätzliche Kapazität zum angelegten periodischen Wechselspannungssignal effektiv gleichgerichtet. Hierbei reagiert der Taktgenerator auf den positiven und negativen Wertebereich des Wechselspannungssignals.

In einem weiteren Ausführungsbeispiel für gemischt kapazitiv-resistiven synaptischen Bauelemente ist der Zeitpunkt für eine Verbindung zwischen Masse und Eingang des Ladungsintegrationsverstärkers beliebig gewählt, jedoch exakt eine halbe Periodendauer lang. Gleiches gilt für den Fall eines differentiellen Verstärkers mit nichtinvertierendem und invertierendem Eingang. Da ein gemischt kapazitiv-resistives synaptischen Bauelement keine feste Phasenbeziehung mehr hat, kann der Zeitpunkt für die Taktsignal Reaktion nicht genau definiert werden. Abhängig von der Phasenverschiebung ist die im Ladungsintegrationsverstärker akkumulierte Ladung unterschiedlich und somit kann die Phase/Zeitpunkte des Wechselspannungssignals an der Wortleitung beliebig gewählt werden. Bevorzugt ist es die Zeitpunkte/Phase entweder dem rein kapazitiven oder resistiven Fall entsprechend zu wählen.

In einer Ausführungsform sind die Wechselspannungssignale harmonisch und positive und negative Wechselspannungssignale sind um 180° phasenverschoben. Harmonische Wechselspannungssignale haben den Vorteil, dass keine Oberwellen auftreten und die Abschirmschicht die Signale gut abschirmen kann und weniger Ladungen in parasitären Kapazitäten verloren gehen. Zudem sind resistive Verluste im Falle von kapazitiven synaptischen Bauelementen geringer, sodass mehr Energie über die vorher erwähnte adiabatische Aufladung zurückgewonnen werden kann.

In einer Ausführungsform kann die Eingangsgröße entweder als veränderliche Anzahl der Perioden, oder als Phasenverschiebung, oder als Amplitudenänderung, oder als Frequenzänderung des Wechselspannungssignals, oder als veränderte DC Komponente des Wechselspannungssignals, oder als Kombination der vorher genannten Änderungen dargestellt werden kann. Da der Ladungsintegrationsverstärker die Aufladung bzw. Endladung über mehrere Perioden auf integriert, kann die Anzahl von Perioden im Wechselspannungssignal dazu benutzt werden, die Eingangsgröße darzustellen. Bisher wurden für positive und negative Eingangssignale nur zwei Phasen benutzt (Phasenverschiebung von 180°). Auch möglich ist es beliebige Phasenverschiebungen dazwischen zu benutzen, zur Darstellung des Eingangssignals zu benutzen: Der Ladungsintegrationsverstärker integriert dabei nicht nur die abfallenden oder aufsteigenden Flanken des Wechselspannungssignales, sondern auch über beide Phasen hinweg, oder über einen geringeren Zeitraum in einer Phase. Dies ermöglicht eine Analogwertdarstellung des Eingangssignals. Ebenfalls ist eine Amplitudenänderung des Wechselspannungssignals denkbar, da hierdurch die Auf- und Entladung geringer oder stärker ausfällt. Eine Frequenzänderung des Wechselspannungssignals führt bei einem festen Integrationszeitraum zu mehr oder weniger Auf- bzw. Entladungen und damit zu einem kleineren bzw. größeren Ausgangssignal von dem Ladungsintegrationsverstärker. Eine veränderte DC Komponente des Wechselspannungssignals kann bei nichtlinearen Bauelementen zu einem veränderten Arbeitspunkt und damit stärkeren oder schwächeren Ausgangssignal führen. Ebenfalls denkbar ist eine Kombination der fünf genannten Möglichkeiten der Eingangswerteinstellung.

In einem weiteren Ausführungsbeispiel können die Gewichte in einer gemischt kapazitiv-resistiven Matrix auch durch den komplexen und realen Anteil bei gleichbleibender Impedanz eingestellt werden können und eine Phasenverschiebung des Wechselspannungssignals bewirken. Die gängige Weise den Gewichtswert zu verändern ist die absolute Impedanz zu variieren, jedoch können gemischt kapazitiv-resistive Gewichtswerte auch in der Phasenbeziehung verändert werden, da das oben erklärte Integrationsschema phasenempfindlich ist. Dies eröffnet eine weitere Möglichkeit den Gewichtswert zu verändern, neben dem absoluten Impedanzwert.

In einer Ausführungsform können mehrere Wechselspannungssignale parallel an die Wortleitungen angelegt werden und diese unterscheiden sich in der Frequenz, und an den Bitleitungen befinden sich jeweils mehrere Ladungsintegrationsverstärker, welche jeweils für die einzelnen Frequenzbänder zuständig sind. Insbesondere in convolutional neural networks wird dieselbe Gewichtsmatrix für mehrere Eingangspixelfelder verwendet. Diese ist normalerweise ein serieller Prozess, indem die Eingangspixelfelder nacheinander angelegt werden. Durch die Verwendung von mehreren Bändern, welche jeweils ein Eingangspixelfeld kann dieser Prozess parallelisiert werden. Die Ladungsintegrationsverstärker müssen dann im Stande sein die Frequenzbänder zu unterscheiden.

In einer weiteren Ausführungsform wird für die Selektion der Bänder ein Bandpassfilter, z.B. in Form eines Lock-in-Verstärker benutzt.

In einer letzten verfahrensseitigen Ausführungsform wird die Frequenz des angelegten Wechselspannungssignals im Falle von kapazitiven synaptischen Bauelementen soweit minimiert wird, dass resistive Verluste in den Zuleitungen der Matrixanordnung und dem kapazitiven synaptischen Bauelement selber um mindestens eine Größenordnung kleiner sind, als die kapazitive Energiezufuhr. Hiermit wird sichergestellt, dass ein großer Teil der zugeführten dynamischen Energie mit dem adiabatischen Ansatz zurückgewonnen werden kann.

Die Erfindung soll nachfolgend anhand mehrerer Ausführungsbeispiele näher erläutert werden. Die zugehörigen Zeichnungen zeigen:

Fig. 1: Schaltungstechnischer Aufbau mit Oszillator, Taktgenerator, Wechselschalter, Ladungsintegrationsverstärker und kapazitiver Matrix, sowie die an die Wortleitungen angelegten Wechselsignale

Fig. 2: Schaltungstechnischer Aufbau und Wechselsignal Relationen für eine resistive Matrix

Fig. 3: Schaltungstechnischer Aufbau und Wechselsignal Relationen für eine kapazitive Matrix mit Ladungsintegrationsverstärker, welcher über einen invertierenden und nichtinvertierenden Eingang verfügt

Fig. 4: Schaltungstechnischer Aufbau und Wechselsignal Relationen für eine kapazitive Matrix mit zusätzlicher fester Kapazität an jeder Bitleitung

Fig. 5: Harmonische Wechselsignale für eine kapazitive Matrix

Fig. 6: Harmonische Wechselsignale für eine gemischt kapazitive-resistive Matrix

Fig. 7: Ladungsintegrationsverstärker mit Stromspiegel

Fig. 8: Ladungsintegrationsverstärker mit Gate-Schaltung

Fig. 9: Einfluss der Phasenverschiebung auf die integrierte Ladung für ein beliebiges Wechselsignal, sowie die Variation der Periodenanzahl und der Amplitude

Fig. 10: Einfluss der Phasenverschiebung auf die integrierte Ladung für ein harmonisches Wechselsignal, sowie die Variation der Periodenanzahl und der Amplitude

Fig. 11: Applikation mehrerer Wechselsignale in verschiedenen Frequenzbändern

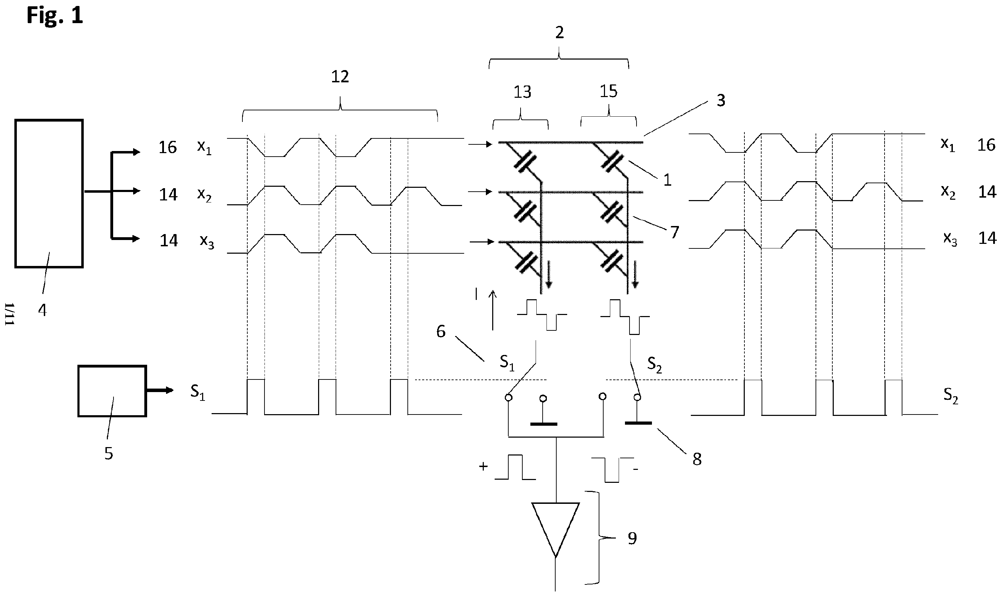

Wie in Fig. 1 dargestellt, werden mehrere Wechselspannungen (12) an die Wortleitungen (3) angelegt, welche sich in der Phase, Amplitude oder der Periodenanzahl unterscheiden. Da in diesem Falle eine kapazitive Matrixanordnung (2) vorliegt, reagieren die kapazitiven synaptischen Bauelemente (2) auf steigende oder fallende Flanken und der Taktgenerator (5) gibt dann ein positives Signal aus, wenn im positiv definierten Wechselspannungssignal (14) eine steigende Flanke vorliegt. In diesem Fall wird der Wechselschalter (S1) die positiv definierten synaptischen Bauelemente (13) mit dem Ladungsintegrationsverstärker (9) verbinden. Der Wechselschalter (S2) verbindet die negativ definierten synaptischen Bauelemente (15) mit Masse (8) in dieser Position, d.h. S1 und S2 schalten entgegengesetzt. Die negativ definierten synaptischen Bauelemente (15) werden dann mit dem Ladungsintegrationsverstärker (9) verbunden, wenn eine fallende Flanke im positiv definierten Wechselspannungssignal (14) vorliegt. Insgesamt führt dies dazu, dass ein positiv definiertes Wechselspannungssignal, eine Aufladung im Ladungsintegrationsverstärker (9) für die positiv definierten synaptischen Bauelemente (13) bewirkt, und eine Entladung für die negativ definierten synaptischen Bauelemente (15) bewirkt. Für negativ definierte Wechselspannungssignal (16) werden die steigende und fallende Flanke zeitlich vertauscht, d.h., die positiv definierten synaptischen Bauelemente (13) bewirken eine Entladung, während die negativ definierten synaptischen Bauelemente (15) eine Aufladung bewirken. Auf diese Weise wird eine Vier-quadranten Multiplikation realisiert.

Die Wechselspannungssignale werden durch Oszillatoren (4) realisiert. Ebenfalls in Fig. 1 dargestellt ist beispielhaft eine kleinere Periodenanzahl für das negativ definierte Wechselspannungssignal (16), als für die positiv definierten Wechselspannungssignale (14). Dies ist eine Möglichkeit den Betrag von dem Eingangssignal zu der Wortleitung (3) einzustellen, da in diesem Beispiel die positiv definierten synaptischen Bauelemente (13) einmal häufiger geladen, als entladen werden.

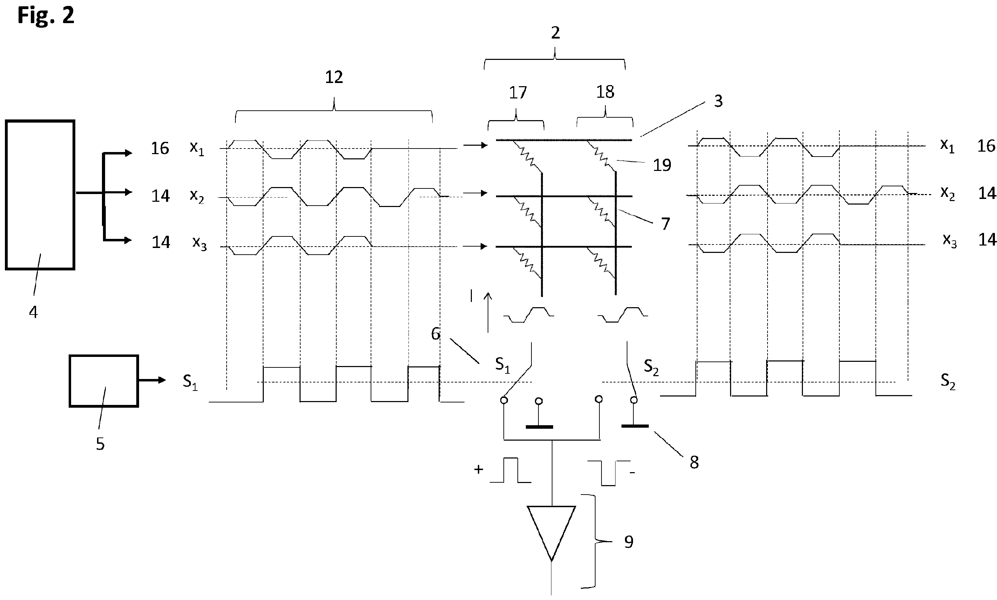

In Fig. 2 wird der Fall für resistive synaptische Bauelemente (19) erläutert. In diesem Fall bewirken die Bauelemente eine Auf- und Entladung für Wechselspannungssignale (12) im positiven und negativen Wertebereich. Entsprechend reagiert der Taktgenerator (5) in dem resistiven Fall auf den positiven und negativen Wertebereich des Wechselspannungssignals, und nicht auf die steigende oder fallende Flanke. Ansonsten ist die Funktionsweise der Wechselschalter (6) identisch zu Fig. 1.

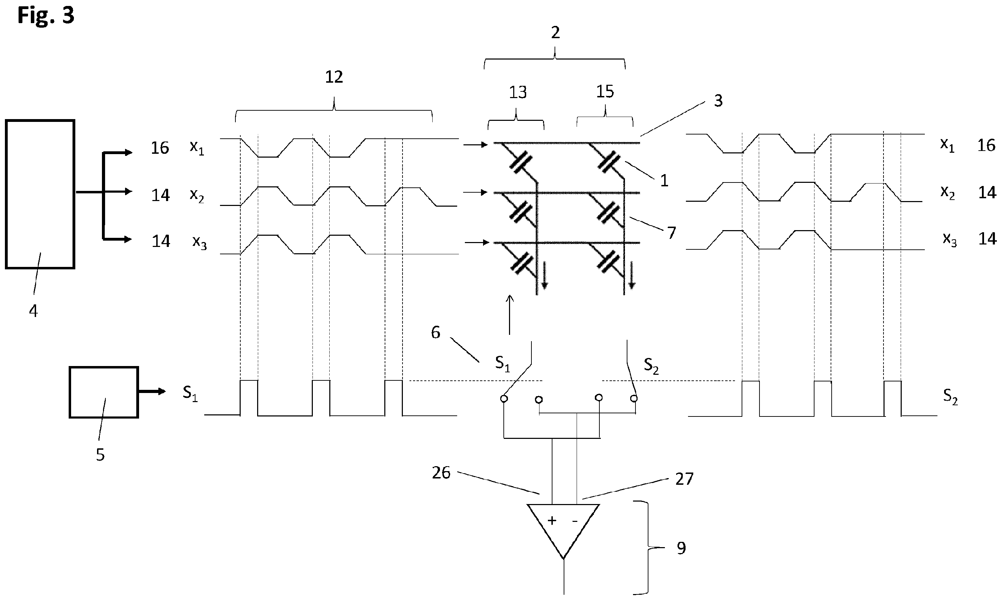

Fig. 3 wird der Fall für einen Ladungsintegrationsverstärker (9) mit nichtinvertierenden (26) und invertierenden (27) Eingang gezeigt. Hierbei wird zwischen den beiden Eingängen hin- und her geschaltet, wodurch beide Phasen genutzt werden und die effektive Verstärkung verdoppelt wird.

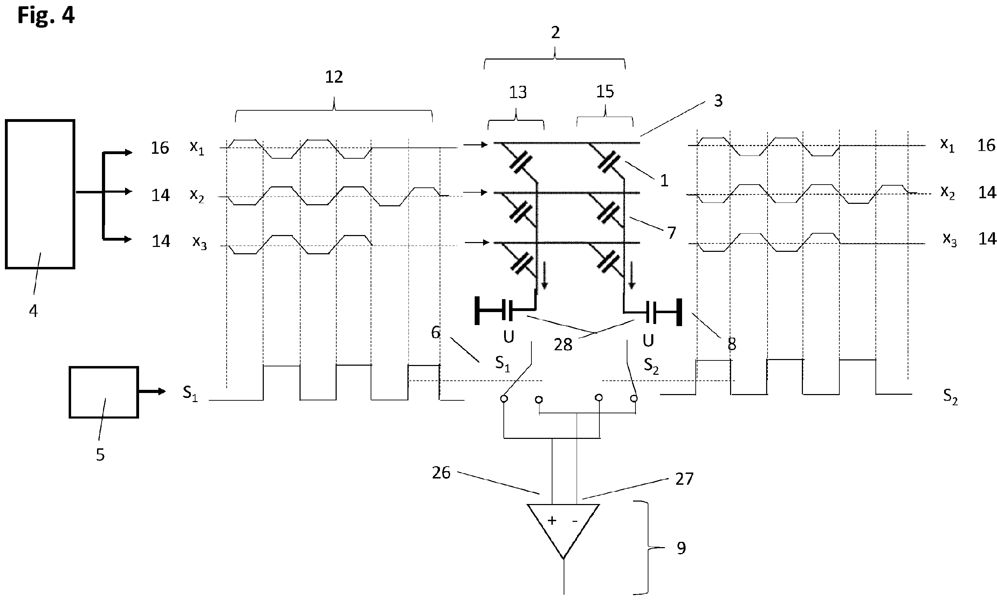

Fig. 4 illustriert den Fall, dass die kapazitive Matrix mit einer festen Kapazität (28) an der Bitleitung (7) mit Masse verbunden. Dies kann beispielsweise die parasitäre Bitleitungskapazität sein. Hierdurch wird der Spannungsabfall über diese Kapazität an den Ladungsintegrationsverstärker (9) geschalten, sodass der Taktgenerator (5) auf den positiven und negativen Wertebereich des Wechselspannungssignals (12) reagiert.

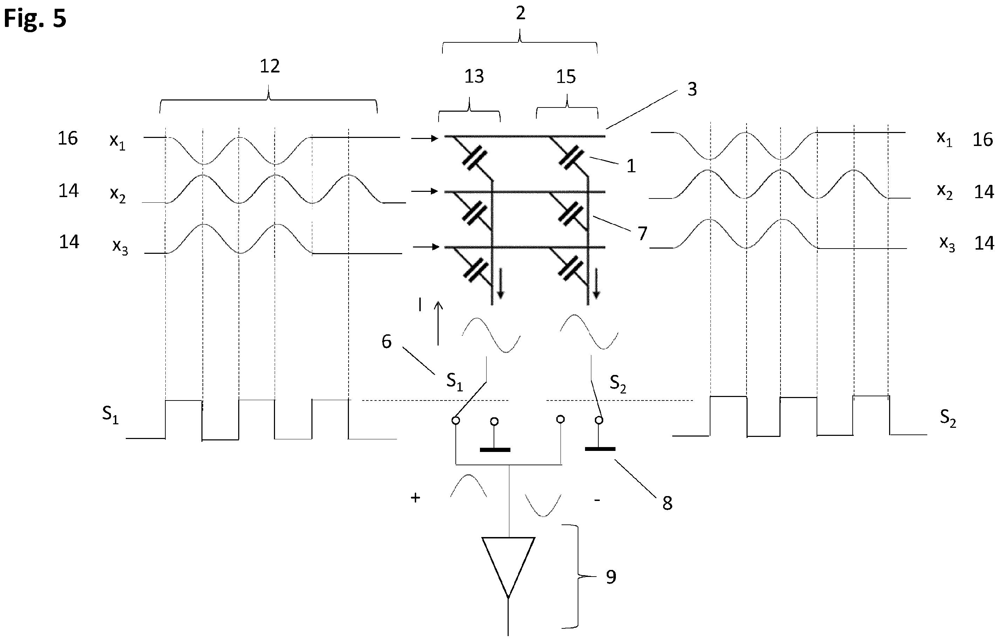

Fig. 5 illustriert dasselbe Prinzip für ein harmonisches Signal.

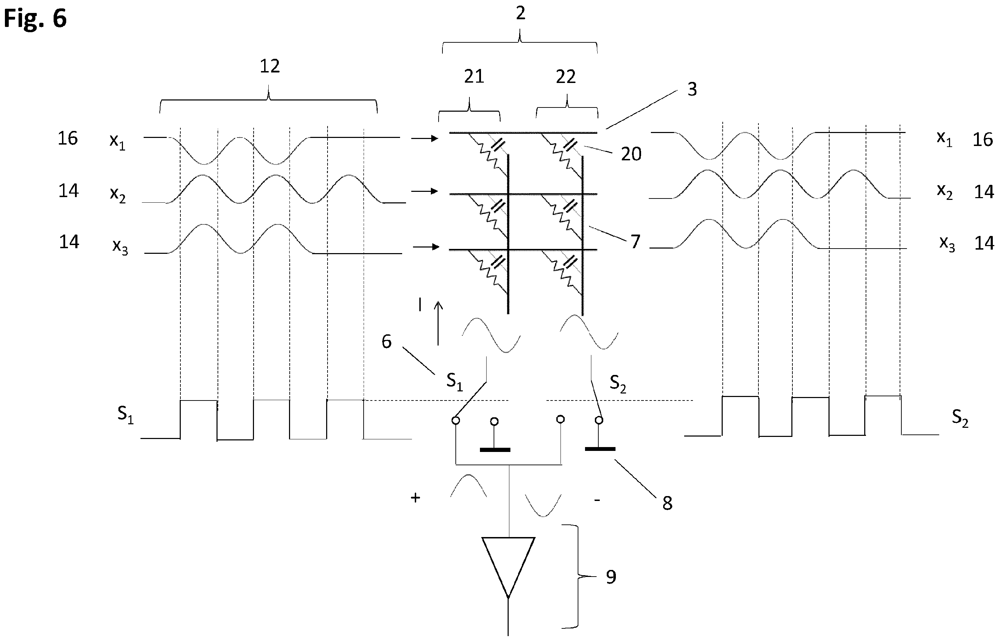

Fig. 6 zeigt das Schema für eine gemischt kapazitiv-resistive Matrix. In diesem Fall reagiert der Taktgenerator (5) mit einer beliebigen Phase zu dem Wechselspannungssignal (12). Die kapazitiv-resistiven Bauelemente (20) führen zu einer beliebig einstellbaren Phasenverschiebung der Auf- und Entladung. Damit kann der Gewichtswert nicht nur durch den absoluten Impedanzwert eingestellt werden, sondern auch durch den komplexen und realen Anteil der Impedanz.

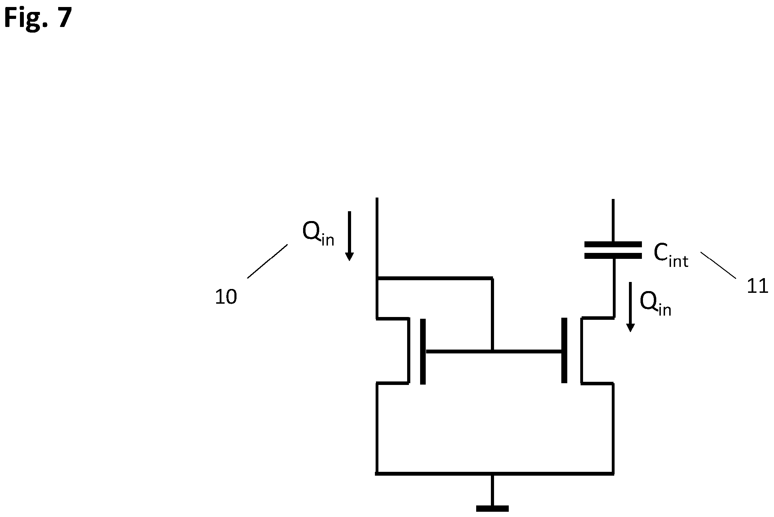

Fig. 7 zeigt einen Ladungsintegrationsverstärker (9) mit einer Stromspiegeltopologie. Der Stromspiegel hat eine niedrige Eingangsimpedanz und spiegelt die Ladung (10) auf einen Integrationskondensator (11)

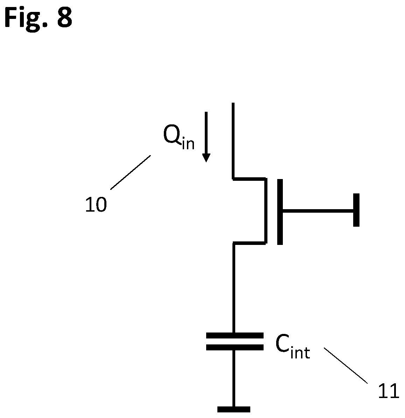

Fig. 8 zeigt einen Ladungsintegrationsverstärker (9) mit einer Gate-Schaltung, welche ebenfalls eine niedrige Eingangsimpedanz besitzt.

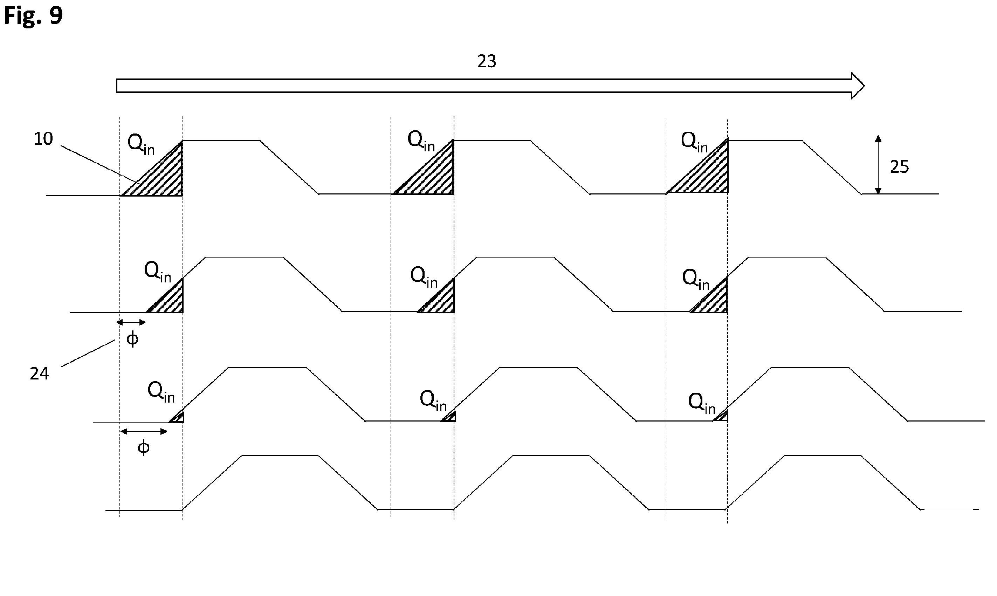

Fig. 9 zeigt die Möglichkeiten für eine Eingangswertdarstellung für das Wechselspannungssignal (12). Eine Möglichkeit ist Änderung der Amplitude (25), weiterhin kann wie bereits erklärt die Periodenanzahl verändert werden. In beiden Fällen werden mehr oder weniger Ladungen über einen Zeitraum auf dem Ladungsintegrationsverstärker (9) akkumuliert. Weiterhin kann auch die Phase (24) verändert werden, da das Wechselspannungssignal (12) wie dargestellt immer nur über bestimmte zeitliche Abschnitte integriert wird. Im obersten Fall wird die komplette ansteigende Flanke integriert. Für die darunterliegenden Wechselspannungssignale (12) wird der Integrationszeitraum (dargestellt als gestrichelte Linie), welcher von der ansteigenden Flanke abgedeckt wird immer geringer. Hierdurch wird die akkumulierte Ladung ebenfalls geringer.

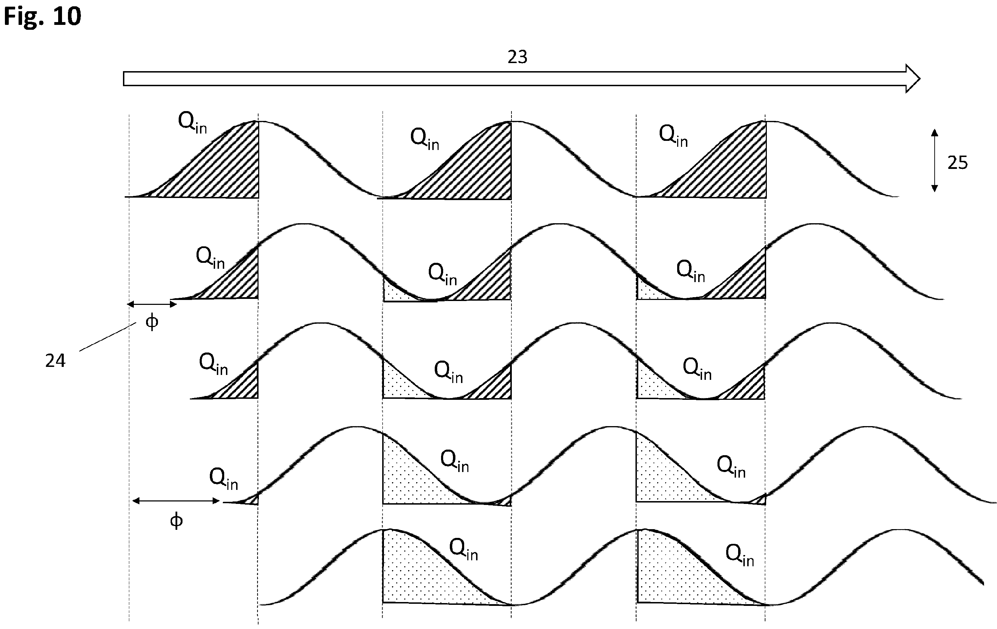

Fig. 10 zeigt denselben Zusammenhang, wie in Fig. 7, nur mit einem harmonischen Signal, wobei der Integrationszeitraum nun die ansteigende und abfallende Flanke umfassen kann. Die unterste Kurve stellt eine 180° Phasenverschiebung dar und umfasst die abfallende Flanke, wohingegen die oberste Kurve die ansteigende Flanke umfasst. In der mittleren Kurve werden die abfallende Flanke und ansteigende Flanke zu gleichen Teilen umfasst, sodass der Integrationswert Null ist in diesem Fall.

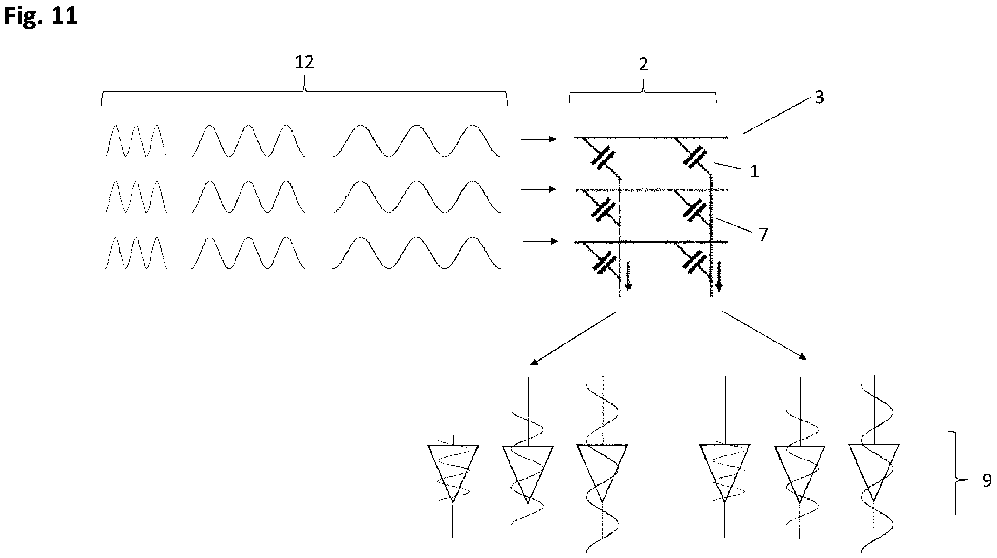

Fig. 11 zeigt die Applikation von mehreren Wechselspannungssignalen (12) auf einmal an die Wortleitungen (3) mit unterschiedlicher Frequenz. Für jedes Frequenzband gibt es einen getrennten Ladungsintegrationsverstärker (9), wodurch mehrere Vektoren mit denselben Gewichten multipliziert werden können. Dieser Fall ist besonders bei convolutional neural networks relevant.

## Bezugszeichenliste

1 kapazitives synaptisches Bauelement
2 Matrixanordnung
3 Wortleitungen
4 Oszillator
5 Taktgenerator
6 Wechselschalter
7 Bitleitungen
8 Masse
9 Ladungsintegrationsverstärker
10 Ladung
11 Integrationskondensator
12 Wechselspannungssignal
13 positiv definiertes kapazitives synaptisches Bauelement
14 positiv definiertes Wechselspannungssignal
15 negativ definiertes kapazitives synaptisches Bauelement
16 negativ definiertes Wechselspannungssignal
17 positiv definiertes resistives synaptisches Bauelement
18 negativ definiertes resistives synaptisches Bauelement
19 resistives synaptisches Bauelement
20 gemischt kapazitiv-resistives synaptisches Bauelement
21 positiv definiertes kapazitiv-resistives synaptisches Bauelement
22 negativ definiertes kapazitiv-resistives synaptisches Bauelement
23 Anzahl von Perioden
24 Phasenverschiebung
25 Amplitudenänderung
26 nichtinvertierender Eingang
27 invertierender Eingang
28 feste Kapazität.

**Patentansprüche**

1. Anordnung zur Durchführung einer Vektor-Matrix-Multiplikation mit synaptischen Bauelemente (1), bestehend aus einer Matrixanordnung (2) von kapazitiven (1) oder resistiven (19) oder gemischt kapazitiv-resistiven synaptischen Bauelementen (20) in einer differentiellen Anordnung, mit einer periodischen Ladung und Entladung, und einem Taktgenerator (5), **dadurch gekennzeichnet, dass**

   - der Taktgenerator die Bitleitungen (7) abwechselnd mit einem Ladungsintegrationsverstärker (9) oder einer Masse (8) über einen Wechselschalter (6) verbindend gestaltet ist, oder abwechselnd mit einem nichtinvertierenden (26) und invertierenden Eingang (27) des Ladungsintegrationsverstärkers über einen Wechselschalter (6) verbindend gestaltet ist,
   - die Wortleitungen (3) mit einem oder mehreren Oszillatoren (4) elektrisch verbunden sind,
   - der Taktgenerator (5) auf eine steigende oder fallende Flanke der Spannung des Oszillators (4) oder auf den positiven und negativen Wertebereich der Spannung des Oszillators (4) reagierend ausgebildet ist.

2. Anordnung nach Anspruch 1, **dadurch gekennzeichnet, dass** der Taktgenerator (5) im Falle von kapazitiven synaptischen Bauelementen (1), insbesondere von positiv (13) und negativ definierten (15) Kapazitäten, auf eine steigende oder fallende Flanke der Spannung des Oszillators (4) reagierend ausgebildet ist.

3. Anordnung nach Anspruch 1, **dadurch gekennzeichnet, dass** die Bitleitung (7) im Falle von kapazitiven synaptischen Bauelementen (1), insbesondere von positiv (13) und negativ definierten (15) Kapazitäten, über eine feste Kapazität (28) mit Masse (8) verbunden ist und der Taktgenerator (5) auf den positiven und negativen Wertebereich der Spannung des Oszillators (4) reagierend ausgebildet ist.

4. Anordnung nach Anspruch 1, **dadurch gekennzeichnet, dass** der Taktgenerator (5) im Falle von resistiven synaptischen Bauelementen (19), insbesondere von positiv (17) und negativ definierten (18) Widerständen, auf den positiven und negativen Wertebereich der Spannung des Oszillators (4) reagierend ausgebildet ist.

5. Anordnung nach Anspruch 1, **dadurch gekennzeichnet, dass** der Ladungsintegrationsverstärker (9) aus einem Stromspiegel die zu messende Ladung (10) zu der Integrationskapazität (11) spiegelnd aufgebaut ist.

6. Anordnung nach Anspruch 1, **dadurch gekennzeichnet, dass** in dem Ladungsintegrationsverstärker (9) die Integrationskapazität (11) über eine Gate-Schaltung mit dem Wechselschalter (6) verbunden ist.

7. Anordnung nach Anspruch 1, **dadurch gekennzeichnet, dass** in dem Ladungsintegrationsverstärker (9) die Integrationskapazität (11) direkt mit dem Wechselschalter (6) verbunden ist.

8. Anordnung nach Anspruch 1, **dadurch gekennzeichnet, dass** in dem Ladungsintegrationsverstärker (9) die Integrationskapazität (11) über den Millereffekt vergrößert am Eingang des Ladungsintegrationsverstärkers (9) erscheint.

9. Anordnung nach Anspruch 1, **dadurch gekennzeichnet, dass** die Oszillatoren (4) über einen Energiespeicher verfügen, welcher die in den kapazitiven synaptischen Bauelementen (1) gespeicherten Ladungen für die weitere Nutzung zurückgewinnen kann.

10. Anordnung nach Anspruch 9, **dadurch gekennzeichnet, dass** der Energiespeicher durch eine Induktivität realisiert wird.

11. Verfahren unter Benutzung der Anordnung nach Anspruch 2, wobei an die Wortleitungen (3) periodische Wechselspannungen (12) angelegt werden, **dadurch gekennzeichnet, dass**

    - die Wechselspannungen (12) einen festen Phasenbezug besitzen,
    - im Falle einer abwechselnden Verbindung zwischen Masse (8) und Eingang des Ladungsintegrationsverstärkers (9) die Bitleitungen (7) der positiv vorgesehenen Kapazitäten (13) dann mit dem Eingang eines Ladungsintegrationsverstärkers (9) verbunden wird, wenn ein positiver Gradient in dem positiv definierten Wechselspannungssignal (14) der Wortleitung (3) vorliegt, ansonsten mit Masse (8) verbunden wird
    - die Bitleitung (7) der als negativ vorgesehenen Kapazitäten (15), dann mit dem Eingang des Ladungsintegrationsverstärkers (9) verbunden wird, wenn ein negativer Gradient im positiv definierten Wechselspannungssignal (14) der Wortleitung (3) vorliegt, ansonsten mit der Masse (8) verbunden wird,

- im Falle einer abwechselnden Verbindung zwischen invertierendem (27) und nichtinvertierendem (28) Eingang des Ladungsintegrationsverstärkers (9)

- die positiv vorgesehenen Kapazitäten (13) dann mit dem nichtinvertierenden Eingang (28) eines Ladungsintegrationsverstärkers (9) verbunden wird, wenn ein positiver Gradient in dem positiv definierten Wechselspannungssignal (14) der Wortleitung (3) vorliegt, ansonsten mit dem invertierenden Eingang (27) und

- die negativ vorgesehenen Kapazitäten (15) dann mit dem nichtinvertierenden Eingang (26) eines Ladungsintegrationsverstärkers (9) verbunden wird, wenn ein negativer Gradient in dem positiv definierten Wechselspannungssignal (14) der Wortleitung (3) vorliegt, ansonsten mit dem invertierenden Eingang (27),

- wobei im Falle eines negativ definierten Wechselspannungssignals (16) an der Wortleitung (3), der positive und negative Gradient zeitlich vertauscht wird.

12. Verfahren unter Benutzung der Anordnung nach Anspruch 3 oder 4, wobei an die Wortleitungen (3) periodische Wechselspannungen (12) angelegt werden, **dadurch gekennzeichnet, dass**

- die Wechselspannungen (12) einen festen Phasenbezug besitzen,

- im Falle einer abwechselnden Verbindung zwischen Masse (8) und Eingang des Ladungsintegrationsverstärkers (9)

- die positiv vorgesehenen Kapazitäten (13) beziehungsweise Widerstände (17) dann mit dem Eingang eines Ladungsintegrationsverstärkers (9) verbunden werden, wenn ein positiver Wertebereich in dem positiv definierten Wechselspannungssignal (14) der Wortleitung (3) vorliegt, ansonsten mit Masse (8) verbunden wird,

- die Bitleitung (7) der als negativ vorgesehenen Kapazitäten (15) beziehungsweise Widerständen (18), dann mit dem Eingang des Ladungsintegrationsverstärkers (9) verbunden wird, wenn ein negativer Wertebereich im positiv definierten Wechselspannungssignal (14) der Wortleitung (3) vorliegt, ansonsten mit der Masse (8) verbunden wird,

- im Falle einer abwechselnden Verbindung zwischen invertierendem (27) und nichtinvertierendem (26) Eingang des Ladungsintegrationsverstärkers (9)

- die positiv vorgesehenen Kapazitäten (13) beziehungsweise Widerständen (17) dann mit dem nichtinvertierenden Eingang (26) eines Ladungsintegrationsverstärkers (9) verbunden wird, wenn ein positiver Wertebereich in dem positiv definierten Wechselspannungssignal (14) der Wortleitung (3) vorliegt, ansonsten mit dem invertierenden Eingang (27) und

- die negativ vorgesehenen Kapazitäten (15) beziehungsweise Widerständen (18) dann mit dem nichtinvertierenden Eingang (26) eines Ladungsintegrationsverstärkers (9) verbunden wird, wenn ein negativer Wertebereich in dem positiv definierten Wechselspannungssignal (14) der Wortleitung (3) vorliegt, ansonsten mit dem invertierenden Eingang (27),

- wobei im Falle eines negativ definierten Wechselspannungssignals (16) an der Wortleitung (3), der positive und negative Wertebereich zeitlich vertauscht wird.

13. Verfahren unter Benutzung der Anordnung nach Anspruch 1, wobei an die Wortleitungen (3) periodische Wechselspannungen (12) angelegt werden, **dadurch gekennzeichnet, dass**

- im Falle von gemischt kapazitiv-resistiven synaptischen Bauelementen (20) und im Falle einer abwechselnden Verbindung zwischen Masse (8) und Eingang des Ladungsintegrationsverstärkers (9)

- die Bitleitung (7) der als positiv vorgesehenen kapazitiv-resistiven Bauelementen (21), zu einem beliebigen Zeitpunkt mit dem Eingang des Ladungsintegrationsverstärkers (9) für einen Zeitraum von einer halben Periodendauer des positiv definierten Wechselspannungssignals (14) verbunden wird, und für einen darauffolgenden Zeitraum mit einer halben Periodendauer des positiv definierten Wechselspannungssignals (14) mit der Masse (8) verbunden wird,

- die Zeiträume für eine Verbindung zwischen Bitleitung (7) und Ladungsintegrationsverstärker (9) und Bitleitung (7) und Masse (8) bei den negativ vorgesehenen kapazitiv-resistiven Bauelementen (22), vertauscht sind,

- im Falle einer abwechselnden Verbindung zwischen invertierendem (27) und nichtinvertierendem (26) Eingang des Ladungsintegrationsverstärkers (9)

- die Bitleitung (7) der als positiv vorgesehenen kapazitiv-resistiven Bauelementen (21), zu einem beliebigen Zeitpunkt mit dem nichtinvertierenden Eingang (26) des Ladungsintegrationsverstärkers (9) für einen Zeitraum von einer halben Periodendauer des positiv definierten Wechselspannungssignals (14) verbunden wird, und für einen darauffolgenden Zeitraum mit einer halben Periodendauer des positiv definierten Wechselspannungssignals (14) mit dem invertierenden Eingang (27) verbunden wird,

- die Zeiträume für eine Verbindung zwischen Bitleitung (7) und nichtinvertierendem Eingang (26) des Ladungsintegrationsverstärkers (9) sowie zwischen Bitleitung (7) und invertierendem Eingang (27) bei den negativ vorgesehenen kapazitiv-resistiven Bauelementen (22), vertauscht sind,

- wobei im Falle eines negativ definierten Wechselspannungssignals (16) an der Wortleitung (3), die beiden Zeiträume ebenfalls vertauscht sind.

14. Verfahren, nach einem der Ansprüche 11 bis 13, **dadurch gekennzeichnet, dass**

- die Wechselspannungssignale (12) harmonisch sind, und
- positive und negative Wechselspannungssignale (14,16) um 180° phasenverschoben sind.

15. Verfahren, nach einem der Ansprüche 11 bis 14, **dadurch gekennzeichnet, dass**

- die Eingangsgröße entweder als veränderliche Anzahl der Perioden (23),
- oder als Phasenverschiebung (24),
- oder als Amplitudenänderung (25),
- oder als Frequenzänderung des Wechselspannungssignals (12),
- oder als veränderte DC Komponente des Wechselspannungssignals (12),
- oder als Kombination der vorher genannten Änderungen dargestellt werden kann.

16. Verfahren nach Anspruch 13, **dadurch gekennzeichnet, dass** die Gewichte in einer gemischt kapazitiv-resistiven Matrix auch durch den komplexen und realen Anteil bei gleichbleibender Impedanz eingestellt werden können und eine Phasenverschiebung des Wechselspannungssignals (12) bewirken.

17. Verfahren, nach einem der Ansprüche 11 bis 14, **dadurch gekennzeichnet, dass** mehrere Wechselspannungssignale (12) parallel an die Wortleitungen (3) angelegt werden und diese sich in der Frequenz unterscheiden, an den Bitleitungen (7) sich jeweils mehrere Ladungsintegrationsverstärker (9) befinden, welche jeweils für die einzelnen Frequenzbänder zuständig sind.

18. Verfahren nach Anspruch 17, **dadurch gekennzeichnet, dass** die Ladungsintegrationsverstärker (9) die passende Frequenz am Eingang mit einem Bandpassfilter selektiert, und beispielsweise in Form eines Lock-in-Verstärkers aufgebaut ist.

19. Verfahren nach einem der Ansprüche 11 bis 18, **dadurch gekennzeichnet, dass** die Frequenz des angelegten Wechselspannungssignals (12) im Falle von kapazitiven synaptischen Bauelementen (1) soweit minimiert wird, dass resistive Verluste in den Zuleitungen der Matrixanordnung (2) und dem kapazitiven synaptischen Bauelement (1) selber um mindestens eine Größenordnung kleiner sind, als die kapazitive Energiezufuhr.

## Claims

1. An arrangement for performing a vector-matrix multiplication by means of synaptic components (1), consisting of a matrix arrangement (2) of capacitive synaptic components (1) or resistive synaptic components (19) or mixed capacitive-resistive synaptic components (20) in a differential arrangement, with periodic charging and discharging, and a clock generator (5), **characterized in that**

the clock generator is designed to alternately connect the bit lines (7) to a charge integration amplifier (9) or ground (8) via a changeover switch (6) or is designed to alternately connect the bit lines (7) to a non-inverting input (26) and an inverting input (27) of the charge integration amplifier via a changeover switch (6),

the word lines (3) are electrically connected to one or more oscillators (4),

the clock generator (5) is designed to react to a rising or falling edge of the voltage of the oscillator (4) or to the positive and negative value range of the voltage of the oscillator (4).

2. The arrangement as claimed in claim 1, **characterized in that**, in the case of capacitive synaptic components (1), in particular positively defined capacitances (13) and negatively defined capacitances (15), the clock generator (5) is designed to react to a rising or falling edge of the voltage of the oscillator (4).

3. The arrangement as claimed in claim 1, **characterized in that**, in the case of capacitive synaptic components (1), in particular positively defined capacitances (13) and negatively defined capacitances (15), the bit line (7) is connected to ground (8) via a fixed capacitance (28) and the clock generator (5) is designed to react to the positive and negative value range of the voltage of the oscillator (4).

4. The arrangement as claimed in claim 1, **characterized in that**, in the case of resistive synaptic components (19), in particular positively defined resistances (17) and negatively defined resistances (18), the clock generator (5) is designed to react to the positive and negative value range of the voltage of the oscillator (4).

5. The arrangement as claimed in claim 1, **characterized in that** the charge integration amplifier (9) is constructed from a current mirror mirroring the charge (10) to be measured to the integration capacitance (11).

6. The arrangement as claimed in claim 1, **characterized in that**, in the charge integration amplifier (9), the integration capacitance (11) is connected to the changeover switch (6) via a gate circuit.

7. The arrangement as claimed in claim 1, **characterized in that**, in the charge integration amplifier (9), the integration capacitance (11) is directly connected to the changeover switch (6).

8. The arrangement as claimed in claim 1, **characterized in that**, in the charge integration amplifier (9), the integration capacitance (11) appears in an enlarged form at the input of the charge integration amplifier (9) via the Miller effect.

9. The arrangement as claimed in claim 1, **characterized in that** the oscillators (4) have an energy store which can recover the charges stored in the capacitive synaptic components (1) for further use.

10. The arrangement as claimed in claim 9, **characterized in that** the energy store is implemented by means of an inductance.

11. A method using the arrangement as claimed in claim 2, wherein periodic AC voltages (12) are applied to the word lines (3), **characterized in that**

the AC voltages (12) have a fixed phase relationship,
in the case of an alternating connection between ground (8) and the input of the charge integration amplifier (9), the bit line (7) of the positively provided capacitances (13) is connected to the input of a charge integration amplifier (9) when there is a positive gradient in the positively defined AC voltage signal (14) of the word line (3), and is otherwise connected to ground (8),
the bit line (7) of the capacitances (15) provided as negative is connected to the input of the charge integration amplifier (9) when there is a negative gradient in the positively defined AC voltage signal (14) of the word line (3), and is otherwise connected to ground (8),
in the case of an alternating connection between the inverting input (27) and the non-inverting input (28) of the charge integration amplifier (9) the positively provided capacitances (13) are connected to the non-inverting input (28) of a charge integration amplifier (9) when there is a positive gradient in the positively defined AC voltage signal (14) of the word line (3), and are otherwise connected to the inverting input (27), and
the negatively provided capacitances (15) are connected to the non-inverting input (26) of a charge integration amplifier (9) when there is a negative gradient in the positively defined AC voltage signal (14) of the word line (3), and are otherwise connected to the inverting input (27),
wherein, in the case of a negatively defined AC voltage signal (16), the positive and negative gradients are swapped in time on the word line (3).

12. A method using the arrangement as claimed in claim 3 or 4, wherein periodic AC voltages (12) are applied to the word lines (3), **characterized in that**

the AC voltages (12) have a fixed phase relationship,
in the case of an alternating connection between ground (8) and the input of the charge integration amplifier (9)
the positively provided capacitances (13) or resistances (17) are connected to the input of a charge integration amplifier (9) when there is a positive value range in the positively defined AC voltage signal (14) of the word line (3), and are otherwise connected to ground (8),
the bit line (7) of the capacitances (15) or resistances (18) provided as negative is connected to the input of the charge integration amplifier (9) when there is a negative value range in the positively defined AC voltage signal (14) of the word line (3), and is otherwise connected to ground (8),
in the case of an alternating connection between the inverting input (27) and the non-inverting input (26) of the charge integration amplifier (9) the positively provided capacitances (13) or resistances (17) are connected to the non-inverting input (26) of a charge integration amplifier (9) when there is a positive value range in the positively defined AC voltage signal (14) of the word line (3), and are otherwise connected to the inverting input (27), and
the negatively provided capacitances (15) or resistances (18) are connected to the non-inverting input (26) of a charge integration amplifier (9) when there is a negative value range in the positively defined AC voltage signal (14) of the word line (3), and are otherwise connected to the inverting input (27),
wherein, in the case of a negatively defined AC voltage signal (16), the positive and negative value ranges are swapped in time on the word line (3).

13. A method using the arrangement as claimed in claim 1, wherein periodic AC voltages (12) are applied to the word lines (3), **characterized in that**

in the case of mixed capacitive-resistive synaptic components (20) and in the case of an alternating connection between ground (8) and the input of the charge integration amplifier (9) the bit line (7) of the capacitive-resistive components (21) provided as positive is connected to the input of the charge integration amplifier (9) at any time for a period of half a period duration of the positively defined AC voltage signal (14) and is connected to ground (8) for a subsequent period of half a period duration of the positively defined AC voltage signal (14),

the periods for a connection between the bit line (7) and the charge integration amplifier (9) and between the bit line (7) and ground (8) are swapped in the case of the negatively provided capacitive-resistive components (22),

in the case of an alternating connection between the inverting input (27) and the non-inverting input (26) of the charge integration amplifier (9) the bit line (7) of the capacitive-resistive components (21) provided as positive is connected to the non-inverting input (26) of the charge integration amplifier (9) at any time for a period of half a period duration of the positively defined AC voltage signal (14) and is connected to the inverting input (27) for a subsequent period of half a period duration of the positively defined AC voltage signal (14),

the periods for a connection between the bit line (7) and the non-inverting input (26) of the charge integration amplifier (9) and between the bit line (7) and the inverting input (27) are swapped in the case of the negatively provided capacitive-resistive components (22),

wherein, in the case of a negatively defined AC voltage signal (16) on the word line (3), the two periods are likewise swapped.

14. The method as claimed in one of claims 11 to 13, **characterized in that**

the AC voltage signals (12) are harmonic, and positive and negative AC voltage signals (14, 16) are phase-shifted through 180°.

15. The method as claimed in one of claims 11 to 14, **characterized in that**

the input variable can be represented either as a variable number of periods (23),

or as a phase shift (24),
or as an amplitude change (25),
or as a frequency change of the AC voltage signal (12),
or as a changed DC component of the AC voltage signal (12),
or as a combination of the changes mentioned above.

16. The method as claimed in claim 13, **characterized in that** the weights in a mixed capacitive-resistive matrix can also be set by means of the complex and real parts for a constant impedance and cause a phase shift of the AC voltage signal (12).

17. The method as claimed in one of claims 11 to 14, **characterized in that** a plurality of AC voltage signals (12) are applied to the word lines (3) in a parallel manner and differ in terms of the frequency, and a plurality of charge integration amplifiers (9) which are each responsible for the individual frequency bands are respectively situated on the bit lines (7).

18. The method as claimed in claim 17, **characterized in that** the charge integration amplifier (9) selects the appropriate frequency at the input using a bandpass filter and is constructed, for example, in the form of a lock-in amplifier.

19. The method as claimed in one of claims 11 to 18, **characterized in that** the frequency of the applied AC voltage signal (12) is minimized in the case of capacitive synaptic components (1) to such an extent that resistive losses in the supply lines of the matrix arrangement (2) and in the capacitive synaptic component (1) itself are smaller by at least one order of magnitude than the capacitive energy supply.

**Revendications**

1. Agencement pour effectuer une multiplication de matrice vectorielle au moyen de composants synaptiques (1), composé d'un réseau matriciel (2) de composants synaptiques capacitifs (1) ou résistifs (19) ou mixtes capacitifs-résistifs (20) dans une configuration différentielle, avec charge et décharge périodiques, et d'un générateur d'horloge (5), **caractérisé en ce que**

le générateur d'horloge est conçu pour connecter alternativement les lignes de bits (7) à un amplificateur d'intégration de charge (9) ou à la masse (8) via un commutateur (6), ou est conçu pour connecter alternativement les lignes de bits (7) à une entrée non inverseuse (26) et à une entrée inverseuse (27) de l'amplificateur d'intégration de charge via un commutateur (6),
les lignes de mots (3) sont connectées électriquement à un ou plusieurs oscillateurs (4),
le générateur d'horloge (5) est conçu pour réagir à un front montant ou descendant de la tension de l'oscillateur (4) ou à la plage de valeurs positive et négative de la tension de l'oscillateur (4).

2. Agencement selon la revendication 1, **caractérisé en ce que**, dans le cas de composants synaptiques capacitifs (1), en particulier de capacités fournies comme positives (13) et de capacités fournies comme négatives (15), le générateur d'horloge (5) est conçu pour réagir à un front montant ou descendant de la tension de l'oscillateur (4).

3. Agencement selon la revendication 1, **caractérisé en ce que**, dans le cas de composants synaptiques capacitifs (1), en particulier de capacités fournies comme positives (13) et de capacités fournies comme négatives (15), la ligne de bits (7) est connectée à la masse (8) via une capacité fixe (28) et le générateur d'horloge (5) est conçu pour réagir à la plage de valeurs positives et négatives de la tension de l'oscillateur (4).

4. Agencement selon la revendication 1, **caractérisé en ce que**, dans le cas de composants synaptiques résistifs (19), en particulier de résistances définies positivement (17) et de résistances définies négativement (18), le générateur d'horloge (5) est conçu pour réagir à la plage de valeurs positive et négative de la tension de l'oscillateur (4).

5. Agencement selon la revendication 1, **caractérisé en ce que** l'amplificateur d'intégration de charge (9) est constitué d'un miroir de courant reproduisant la charge (10) à mesurer sur la capacité d'intégration (11).

6. Agencement selon la revendication 1, **caractérisé en ce que**, dans l'amplificateur d'intégration de charge (9), la capacité d'intégration (11) est reliée au commutateur (6) par l'intermédiaire d'un circuit de grille.

7. Agencement selon la revendication 1, **caractérisé en ce que**, dans l'amplificateur d'intégration de charge (9), la capacité d'intégration (11) est directement connectée au commutateur (6).

8. Agencement selon la revendication 1, **caractérisé en ce que**, dans l'amplificateur d'intégration de charge (9), la capacité d'intégration (11) apparaît sous une forme amplifiée à l'entrée de l'amplificateur d'intégration de charge (9) par l'effet Miller.

9. Agencement selon la revendication 1, **caractérisé en ce que** les oscillateurs (4) comportent un accumulateur d'énergie capable de récupérer les charges stockées dans les composants synaptiques capacitifs (1) en vue d'une utilisation ultérieure.

10. Agencement selon la revendication 9, **caractérisé en ce que** le un accumulateur d'énergie est mis en œuvre au moyen d'une inductance.

11. Procédé utilisant l'agencement selon la revendication 2, dans lequel des tensions alternatives périodiques (12) sont appliquées aux lignes de mots (3), **caractérisé en ce que**

les tensions alternatives (12) ont une relation de phase fixe,
dans le cas d'une connexion alternée entre la masse (8) et l'entrée de l'amplificateur d'intégration de charge (9), la ligne de bits (7) des capacités (13) alimentées en tension positive est connectée à l'entrée de l'amplificateur d'intégration de charge (9) lorsqu'il y a un gradient positif dans le signal de tension alternative (14) défini comme positif de la ligne de mots (3), et est sinon connectée à la masse (8),
la ligne de bits (7) des capacités fournies comme négatives (15) est connectée à l'entrée de l'amplificateur d'intégration de charge (9) lorsqu'il y a un gradient négatif dans le signal de tension alternative (14) défini comme positif de la ligne de mots (3), et est sinon connectée à la masse (8),
dans le cas d'une connexion alternée entre l'entrée inverseuse (27) et l'entrée non inverseuse (28) de l'amplificateur d'intégration de charge (9)
les capacités (13) fournies comme positives sont connectées à l'entrée non inverseuse (28) d'un amplificateur d'intégration de charge (9) lorsqu'il y a un gradient positif dans le signal de tension alternative (14) défini comme positif de la ligne de mots (3), et sont sinon connectées à l'entrée inverseuse (27), et
les capacités fournies comme négatives (15) sont connectées à l'entrée non inverseuse (26) d'un amplificateur d'intégration de charge (9) lorsqu'il y a un gradient négatif dans le signal de tension alternative (14) défini comme positif de la ligne de mots (3), et sont sinon connectées à l'entrée inverseuse (27),
dans lequel, dans le cas d'un signal de tension alternative (16) défini comme négatif, les gradients positif et négatif sont inversés dans le temps sur la ligne de mots (3).

12. Procédé utilisant l'agencement selon la revendication 3 ou 4, dans lequel des tensions alternatives périodiques (12) sont appliquées aux lignes de mots (3), **caractérisé en ce que**

les tensions alternatives (12) ont une relation de phase fixe,

dans le cas d'une connexion alternée entre la masse (8) et l'entrée de l'amplificateur d'intégration de charge (9)

les capacités (13) ou résistances (17) fournies comme positives sont connectées à l'entrée d'un amplificateur d'intégration de charge (9) lorsqu'il y a une plage de valeurs positives dans le signal de tension alternative (14) défini comme positif de la ligne de mots (3), et sont sinon connectées à la masse (8),

la ligne de bits (7) des capacités (15) ou des résistances (18) fournies comme négatives est connecté à l'entrée de l'amplificateur d'intégration de charge (9) lorsqu'il y a une plage de valeurs négatives dans le signal de tension alternative (14) défini comme positif de la ligne de mots (3), et est sinon connectée à la masse (8),

dans le cas d'une connexion alternée entre l'entrée inverseuse (27) et l'entrée non inverseuse (26) de l'amplificateur d'intégration de charge (9)

les capacités (13) ou résistances (17) fournies comme positives sont connectées à l'entrée non inverseuse (26) d'un amplificateur d'intégration de charge (9) lorsqu'il y a une plage de valeurs positives dans le signal de tension alternative (14) défini comme positif de la ligne de mots (3), et sont sinon connectées à l'entrée inverseuse (27), et

les capacités (15) ou résistances (18) fournies comme négatives sont connectées à l'entrée non inverseuse (26) d'un amplificateur d'intégration de charge (9) lorsqu'il y a une plage de valeurs négatives dans le signal de tension alternative (14) défini comme positif de la ligne de mots (3), et sont sinon connectées à l'entrée inverseuse (27),

dans lequel, dans le cas d'un signal de tension alternative (16) défini négativement, les plages de valeurs positives et négatives sont permutées dans le temps sur la ligne de mots (3).

13. Procédé utilisant l'agencement selon la revendication 1, dans lequel des tensions alternatives périodiques (12) sont appliquées aux lignes de mots (3), **caractérisé en ce que**

dans le cas de composants synaptiques mixtes capacitifs-résistifs (20) et dans le cas d'une connexion alternée entre la masse (8) et l'entrée de l'amplificateur d'intégration de charge (9)

la ligne de bits (7) des composants capacitifs-résistifs (21) fournis de manière positive est reliée à l'entrée de l'amplificateur d'intégration de charge (9) à tout moment pendant une demi-période du signal de tension alternative (14) défini comme positif, et est reliée à la masse (8) pendant la demi-période suivante du signal de tension alternative (14) défini comme positif, les périodes de connexion entre la ligne de bits (7) et l'amplificateur d'intégration de charge (9) et entre la ligne de bits (7) et la masse (8) sont inversées dans le cas des composants capacitifs-résistifs (22) fournis de manière négative,

dans le cas d'une connexion alternée entre l'entrée inverseuse (27) et l'entrée non inverseuse (26) de l'amplificateur d'intégration de charge (9)

la ligne de bits (7) des composants capacitifs-résistifs (21) fournis de manière positive est connectée à l'entrée non inverseuse (26) de l'amplificateur d'intégration de charge (9) à tout moment pendant une période d'une demi-période du signal de tension alternative (14) défini comme positif et est reliée à l'entrée inverseuse (27) pendant une période suivante d'une demi-période du signal de tension alternative (14),

les périodes de connexion entre la ligne de bits (7) et l'entrée non inverseuse (26) de l'amplificateur d'intégration de charge (9) et entre la ligne de bits (7) et l'entrée inverseuse (27) sont inversées dans le cas des composants capacitifs-résistifs (22) fournis de manière négative,

dans lequel, dans le cas d'un signal de tension alternative (16) défini négativement sur la ligne de mots (3), les deux périodes sont également inversées.

14. Procédé selon l'une des revendications 11 à 13, **caractérisé en ce que**

les signaux de tension alternative (12) sont harmoniques, et

les signaux de tension alternative positifs et négatifs (14, 16) sont déphasés de 180°.

15. Procédé selon l'une des revendications 11 à 14, **caractérisé en ce que**

la variable d'entrée est soit un nombre variable de périodes (23),

soit un déphasage (24),

soit une variation d'amplitude (25),

soit une variation de fréquence du signal de tension alternative (12),

soit une composante continue modifiée du signal de tension alternative (12),

ou soit une combinaison des variations mentionnées ci-dessus.

16. Procédé selon la revendication 13, **caractérisé en**

**ce que** les poids dans une matrice mixte capacitive-résistive peuvent également être réglés au moyen des parties complexes et réelles pour une impédance constante et provoquent un déphasage du signal de tension alternative (12).

17. Procédé selon l'une des revendications 11 à 14, **caractérisé en ce qu'**une pluralité de signaux de tension alternative (12) sont appliqués aux lignes de mots (3) de manière parallèle et diffèrent en termes de fréquence, et qu'une pluralité d'amplificateurs d'intégration de charge (9), qui sont chacun responsables des bandes de fréquences individuelles, sont respectivement situés sur les lignes de bits (7).

18. Procédé selon la revendication 17, **caractérisé en ce que** l'amplificateur d'intégration de charge (9) sélectionne la fréquence appropriée à l'entrée à l'aide d'un filtre passe-bande et est conçu, par exemple, sous la forme d'un amplificateur à verrouillage.

19. Procédé selon l'une des revendications 11 à 18, **caractérisé en ce que** la fréquence du signal de tension alternative (12) appliqué est minimisée dans le cas de composants synaptiques capacitifs (1) à un point tel que les pertes résistives dans les lignes d'alimentation du agencement matriciel (2) et dans le composant synaptique capacitif (1) lui-même sont inférieures d'au moins un ordre de grandeur à l'apport d'énergie capacitif.

Fig. 1

**Fig. 2**

# Fig. 3

EP 4 143 828 B1

Fig. 4

Fig. 5

Fig. 6

EP 4 143 828 B1

**Fig. 7**

Fig. 8

## Fig. 9

EP 4 143 828 B1

**Fig. 10**

Fig. 11

EP 4 143 828 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20180019011 A1
- US 20120014170 A1
- WO 2011025495 A1
- DE 102014105639 B3
- US 5524092 A1
- US 2019303744 A1
- WO 2016068886 A1
- CN 110991623 A
- US 5343555 A

**In der Beschreibung aufgeführte Nicht-Patentliteratur**

- **VENTRA et al.** Circuit elements with memory-memristors, memcapacitors, and meminductors. *Proceedings of the IEEE*
- **TSAI et al.** *Recent progress in analog memory-based accelerators for deep learning*